# EUROPÄISCHE PATENTSCHRIFT

(11) **EP 3 499 563 B1**
(45) Veröffentlichungstag und Bekanntmachung des Hinweises auf die Patenterteilung: **15.04.2020**
(21) Anmeldenummer: 17206911.4
(22) Anmeldetag: 13.12.2017
(51) Int. Cl.: H01L 23/40, H01L 23/467, H01L 23/373

(54) **LEISTUNGSHALBLEITERMODUL UND VERFAHREN ZUR KRAFTSCHLÜSSIGEN ANORDNUNG EINES LEISTUNGSHALBLEITERMODULS**
SEMICONDUCTOR POWER MODULE AND METHOD FOR ASSEMBLING A SEMICONDUCTOR POWER MODULE IN A FORCE-FITTING MANNER
MODULE SEMI-CONDUCTEUR DE PUISSANCE ET PROCÉDÉ DE POSITIONNEMENT EN FORCE D'UN MODULE SEMI-CONDUCTEUR DE PUISSANCE

(43) Veröffentlichungstag der Anmeldung: 19.06.2019
(73) Patentinhaber: SEMIKRON Elektronik GmbH & Co. KG, 90431 Nürnberg (DE)
(72) Erfinder: Cardi, Valeriano, 00165 Rom (IT); Sterpone, Benito, 00041 Albano (IT); Reußer, Lars, 90489 Nürnberg (DE)

(56) Entgegenhaltungen:
- JP-A- 2004 363 521
- US-A- 5 793 106

## Beschreibung

Die Erfindung beschreibt ein Leistungshalbleitermodul mit einem Gehäuse und einer Schaltungseinrichtung, zur Anordnung auf einem Grundkörper, wobei die Schaltungseinrichtung eine Schaltungsträgerplatte mit einer zweiten Oberfläche, die dazu ausgebildet ist, in Richtung auf einer korrespondierenden dritten Oberfläche des Grundkörpers zugewandt zu sein, aufweist. Die Erfindung beschreibt weiterhin ein Verfahren dieses Leistungshalbleitermoduls auf dem Grundkörper kraftschlüssig anzuordnen.

Aus dem allgemeinen Stand der Technik sind Leistungshalbleitermodule bekannt, die eine Schalteinrichtung zur Anordnung auf einem Grundkörper, der in der Regel als Kühleinrichtung, also als Kühlkörper, ausgebildet ist, aufweisen. Diese Schalteinrichtungen werden fachüblich von einem Gehäuse, häufig becherförmig, umschlossen. Das Gehäuse weist eine Befestigungseinrichtung auf, die fachüblich häufig als Ausnehmungen zur Durchführung von Schrauben als Befestigungsmittel ausgebildet sind. Bei der kraftschlüssigen Verbindung des Leistungshalbleitermoduls mit dem Kühlkörper, wird eine dem Kühlkörper zugewandte Oberfläche des Gehäuses mittels dieser Schrauben auf dem Kühlkörper angeordnet. Bei Vorhandensein einer Mehrzahl von Ausführungen zur Durchführung von Schrauben und wenn die Oberfläche des Gehäuses von der Oberfläche des Kühlkörpers nach dem losen Anordnen des Leistungshalbleitermoduls auf dem Kühlkörper von diesem beabstandet ist, kann es während des Einschraubens, insbesondere der ersten Schrauben, zu einer Verkippung des Gehäuses kommen, die im Rahmen der weiteren Befestigung zu einer Verkantung der Schalteinrichtung und sogar zur deren Beschädigung führen kann.

US 5 793 106 A (YASUKAWA AKIO [JP] ET AL) 11. August 1998 (1998-08-11) beschreibt ein Leistungshalbleitermodul .

In Kenntnis der genannten Gegebenheiten, liegt der Erfindung die Aufgabe zugrunde, ein Leistungshalbleitermodul mit einem Gehäuse und einer Schaltungseinrichtung, sowie ein Verfahren zu dessen kraftschlüssiger Anordnung auf einem Grundkörper vorzustellen, wobei eine Verkippung des Gehäuses während der Befestigung verringert wird.

Diese Aufgabe wird erfindungsgemäß durch ein Leistungshalbleitermodul mit den Merkmalen des Anspruchs 1 gelöst, sowie durch ein Verfahren mit den Merkmalen des Anspruchs 5. Bevorzugte Ausführungsformen sind in jeweiligen abhängigen Ansprüchen beschrieben.

Das erfindungsgemäße Leistungshalbleitermodul ist ausgebildet mit einem Gehäuse und mit einer Schaltungseinrichtung zur Anordnung auf einem Grundkörper, wobei die Schaltungseinrichtung eine Schaltungsträgerplatte mit einer zweiten Oberfläche aufweist, die dazu ausgebildet ist auf einer korrespondierenden dritten Oberfläche des Grundkörper angeordnet zu werden, wobei auf der der zweiten Oberfläche abgewandten Seite der Schaltungsträgerplatte weitere Komponenten angeordnet sind, wobei das Gehäuse die Schaltungseinrichtung zumindest an zwei einander gegenüber liegenden Seiten, zumindest teilweise umschließt und dort jeweils eine Befestigungseinrichtung aufweist, wobei genau eine oder mindestens eine erste Befestigungseinrichtung eine erste Oberfläche aufweist, die eine parallel und versetzt zur zweiten Oberfläche angeordnet und gegenüber der zweiten, aus Richtung der dritten Oberfläche, zurückversetzt ist und wobei die Befestigungseinrichtung ein Anschlagelement aufweist, das dazu ausgebildet ist eine erste Kraft, die die erste Oberfläche in Richtung der dritten Oberfläche drückt, ohne eigene Verformung, aufzunehmen und weiterhin bei einer zweiten, in die gleiche Richtung wirkenden, Kraft verformt zu werden.

Vorzugsweise ist hierbei der Fuß 162 des Anschlagelements 16 in einer Vertiefung 18 der zugeordneten Befestigungseinrichtungen 14 angeordnet. Das Anschlagelement ist hier bevorzugt einstückig mit der Befestigungseinrichtung und dieses selbstverständlich einstückig mit dem Gehäuse ausgebildet. Unter dem Fuß des Anschlagelements wird in jedem Fall der Bereich des Anschlagelementes verstanden an dem dieses in die Befestigungseinrichtung übergeht, oder an ihr in sonstiger Weise angeordnet ist.

Das Anschlagelement selbst ist insbesondere zylinder- oder kegelstumpfförmig ausgebildet.

Es ist bevorzugt, wenn die jeweilige Befestigungseinrichtung 14, 12 eine Ausnehmung 146, 126 zur Durchführung eines Befestigungsmittels 50, insbesondere ausgebildet als eine Schraube 54, aufweist.

Das erfindungsgemäße Verfahren zur kraftschlüssigen Anordnung eines oben genannten Leistungshalbleitermoduls auf einer dritten Oberfläche 340 eines Grundkörpers 30, insbesondere ausgebebildet als eine Kühleinrichtung, weist mindestens die folgenden Verfahrensschritte auf:
a) Loses Anordnen des Leistungshalbleitermoduls 1 mit seiner zweiten Oberfläche 240 auf der dritten Oberfläche 340, wobei zwischen der dritten Oberfläche 340 und der ersten Oberfläche 140 ein Abstand 440 besteht;
b) Beaufschlagen der ersten Befestigungseinrichtung 14 mit einer ersten Kraft 40, wodurch eine der dritten Oberfläche 340 zugewandte Kontaktfläche 160 des Anschlagelements 16 in Kontakt mit dieser dritten Oberfläche 340 verbracht wird, ohne dass das Anschlagelement 16 verformt wird; hierunter soll selbstverständlich verstanden werden, dass sich das Anschlagelement nicht in signifikanter Weise, aber ggf. doch im Rahmen des technisch unabdingbaren verformt; die Kontaktfläche kann bereits im Schritt a) auf der dritten Oberfläche lose aufliegen, sie kann aber auch erst während dieses Verfahrensschritts in diese Position verbracht werden;
c) Beaufschlagen einer weiteren Befestigungseinrichtung 12 mit einer weiteren Kraft;
d) Beaufschlagen der ersten Befestigungseinrichtung 14 mit einer zweiten Kraft 42, wodurch das Anschlagelement 16 verformt wird und somit der Abstand zwischen der ersten Oberfläche 140 und der dritten Oberfläche 340 verringert wird.

Es kann vorteilhaft sein, wenn bereits beim Schritt a) zwischen der zweiten 240 und dritten Oberfläche 340 eine, insbesondere thermisch leitende, Zwischenschicht 32 angeordnet ist.

In einer vorteilhaften Ausgestaltung erfolgt das Beaufschlagen des ersten Befestigungseinrichtung 14 mittels eines ersten, insbesondere als eine Schraube 54 ausgebildeten, Befestigungsmittels 50, wobei das Befestigungsmittel 50 durch eine Ausnehmung 146 der zugeordneten Befestigungseinrichtung 14 ragt und sich in einem Widerlager, insbesondere einem Sackloch mit Innengewinde, des Grundkörpers 30 abstützt.

In einer alternativen Ausgestaltung erfolgt das Beaufschlagen der ersten Befestigungseinrichtung 14 mittels eines ersten, insbesondere als eine Klemmeinrichtung 52 ausgebildeten, Befestigungsmittels 50, wobei das Befestigungsmittel sich in einem Widerlager 36 des Grundkörpers 30 abstützt.

Es kann vorteilhaft sein, wenn beim Schritt d) die erste Oberfläche 140 in Kontakt mit der dritten Oberfläche 340 verbracht wird.

In einer bevorzugten Variante kann ein Fuß 162 des Anschlagelements 16 in einer Vertiefung 18 der zugeordneten Befestigungseinrichtungen 14 angeordnet sein und beim Schritt d) das Anschlagelement 16 derart verformt werden, dass ein ursprünglich über die erste Oberfläche 140 in Richtung der dritten Oberfläche 340 hinausstehender Abschnitt 164 des Anschlagelements 16 teilweise oder vollständig, vorzugsweise in diese Vertiefung 18 hinein, verformt wird.

Im Rahmen des Verfahrensschritts d) kann ein Teilabschnitt 142 der ersten Befestigungseinrichtung 14 reversibel oder irreversibel verformt werden. Hierbei wird unter einem Teilabschnitt nicht zwangsläufig ein fest begrenzter Bereich verstanden, vielmehr kann dieser Teilabschnitt kontinuierlich in einen Abschnitt übergehen der nicht verformt wird.

Besonders vorteilhaft an dem Verfahren ist, dass bei zwei sich gegenüberliegenden Befestigungseinrichtungen erst diejenige mit einem oder mehreren Anschlagelementen mit einer ersten Kraft beaufschlagt wird. Somit erfolgt eine Befestigung des Leistungshalbleitermoduls an dieser Stelle, wobei das Leistungshalbleitermodul als Ganzes eine gewisse Verkippung in Richtung dieser ersten Befestigungseinrichtung erfährt, die allerdings geringer ist als bei einem Leistungshalbleitermodul nach dem Stand der Technik. Durch das Befestigen der zweiten Befestigungseinrichtung, wobei hier gleich eine zweite Kraft aufgewendet werden kann erfolgt eine Verkippung in die entgegengesetzte Richtung. Durch weiteres Befestigen der ersten Befestigungseinrichtung mit einer zweiten Kraft erfolgt nun die plane Befestigung des Leistungshalbleitermoduls auf dem Grundkörper. Insgesamt bleibt festzustellen, dass durch das erfindungsgemäße Verfahren die maximale Verkippung des Leistungshalbleitermoduls gegenüber dem Grundkörper geringer ist als gemäß dem Stand der Technik. Somit ist das Risiko einer Beschädigung des Leistungshalbleitermoduls während der Befestigung auf dem Grundkörper signifikant verringert.

Aus produktionstechnischen oder sonstigen Gründen kann es vorteilhaft sein, wenn nicht nur eine, sondern mehrere, insbesondere auch alle Befestigungseinrichtungen mindestens ein Anschlagelement aufweisen. Besonders bevorzugt ist es, wenn bezüglich der Anschlagelemente alle Befestigungseinrichtungen gleichartig ausgebildet sind.

Selbstverständlich können, sofern dies nicht explizit oder per se ausgeschlossen ist oder dem Gedanken der Erfindung widerspricht, die jeweils im Singular genannten Merkmale, insbesondere das Anschlagelement, oder Gruppen von Merkmalen mehrfach in der erfindungsgemäßen leistungselektronische Schalteinrichtung vorhanden sein.

Es versteht sich, dass die verschiedenen Ausgestaltungen der Erfindung, unabhängig davon ob sie in Zusammenhang mit dem Leistungshalbleitermodul oder mit den Verfahren genannt sind, einzeln oder in beliebigen Kombinationen realisiert sein können, um Verbesserungen zu erreichen. Insbesondere sind die vorstehend und im Folgenden genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterungen der Erfindung, vorteilhafte Einzelheiten und Merkmale, ergeben sich aus der nachfolgenden Beschreibung der in den Figuren 1 bis 7 schematisch dargestellten Ausführungsbeispiele der Erfindung, oder von jeweiligen Teilen hiervon.

Figuren 1 bis 3 zeigen eine erste Ausgestaltung eines erfindungsgemäßen Leistungshalbleitermoduls angeordnet auf einem als Kühleinrichtung ausgebildeten Grundkörper und in verschiedenen Phasen des erfindungsgemäßen Verfahrens.

Figur 4 zeigt eine zweite Ausgestaltung eines erfindungsgemäßen Leistungshalbleitermoduls angeordnet auf einer Kühleinrichtung.

Figuren 5 bis 7 zeigen eine dritte Ausgestaltung eines erfindungsgemäßen Leistungshalbleitermoduls in verschiedenen Ansichten.

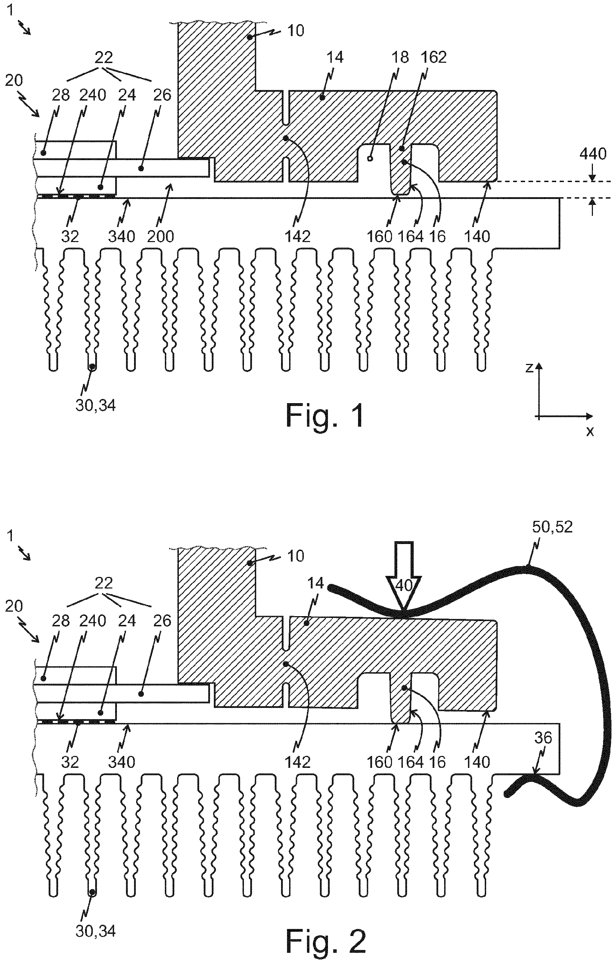

Figuren 1 bis 3 zeigen eine erste Ausgestaltung eines erfindungsgemäßen Leistungshalbleitermoduls 1 angeordnet auf einem als Kühleinrichtung 34 ausgebildeten Grundkörper 30 und in verschiedenen Phasen des erfindungsgemäßen Verfahrens.

Dargestellt ist jeweils ein Ausschnitt einer Kühleinrichtung 34, hier einer Luftkühleinrichtung. Auf einer, der dritten Oberfläche 340 dieser Luftkühleinrichtung ist ein Leistungshalbleitermodul 1, das ebenfalls nur im Ausschnitt dargestellt ist angeordnet.

Hierzu ist auf der dritten Oberfläche 340 eine Wärmeleitpaste 32 angeordnet, auf der die also die Schaltungsträgerplatte 22 des Leistungshalbleitermoduls 1 angeordnet ist. Diese Schaltungsträgerplatte 22 weist eine erste metallische Schicht 24 mit einer zweiten Oberfläche 240 auf, die in unmittelbarem Kontakt mit der Wärmeleitpaste 32 befindet. In Richtung weg von der Kühleinrichtung 34 folgt auf diese metallische Schicht 24 eine Isolierstoffschicht 26 und danach eine zweite metallische Schicht 28. Diese zweite metallische Schicht 28 bildet fachüblich Leiterbahnen des Leistungshalbleitermoduls 1 aus, auf denen, nicht dargestellt Leistungshalbleiterbauelemente angeordnet sind. Die Schaltungsträgerplatte 22, die Leistungshalbleiterbauelemente und weitere Komponenten, wie nicht dargestellte Verbindungs- und Anschlusselemente bilden die Schalteinrichtung 20 des Leistungshalbleitermoduls 1 aus.

Weiterhin dargestellt ist eine Seite des Gehäuses 10 des Leistungshalbleitermoduls 1 und eine erste dort angeordnete Befestigungseinrichtung 14. Diese ist einstückig mit dem Gehäuse 10 und somit als ein Teil dieses Gehäuses ausgebildet. Ein Teilabschnitt 142 dieser Befestigungseinrichtung 14 ist hier verformbar ausgebildet und kann sich gegenüber dem restlichen Gehäuse in gewissen Grenzen bewegen.

Die Befestigungseinrichtung 14 weist eine erste, der dritten Oberfläche 340 der Kühleinrichtung 34 zugewandte erste Oberfläche 140 auf. Von dieser ersten Oberfläche 140 ins Innere der ersten Befestigungseinrichtung 14 hinein erstreckt sich eine Vertiefung 18. In dieser Vertiefung 18 ist ein Anschlagelement 16 angeordnet, das hier aus der Bodenfläche der Vertiefung 18 hervorsteht und einstückig mit der Befestigungseinrichtung 16 ausgebildet ist. Somit ist der Fuß 162 dieses Anschlagelements 16, also derjenige Teil bei dem die Befestigungseinrichtung 14 in das Anschlagelement 16 übergeht, in der Vertiefung 18 angeordnet. Das Anschlagelement 16 weist weiterhin eine Kontaktfläche 160 auf, die dafür vorgesehen ist mit der dritten Oberfläche 340 in Kontakt zu treten. Das Anschlagelement 16 selbst weist eine kegelstupfförmige Ausgestaltung auf.

Figur 1 zeigt die Anordnung aus Leistungshalbleitermodul 1 und Kühleinrichtung 34 gemäß Verfahrensschritt a). Hierbei ist die erste Oberfläche 140 parallel zur dritten 340 und somit auch zur zweiten Oberfläche 240 ausgerichtet. Die erste Oberfläche 140 weist allerdings einen Abstand 440 von der dritten Oberfläche 340 auf, ist also in Richtung weg von der dritten Oberfläche 340 gegenüber der zweiten Oberfläche 240 zurückversetzt. Im Grunde nicht notwendigerweise, aber gemäß dieser Ausgestaltung ist die Kontaktfläche 160 des Anschlagelements 16 ebenfalls von der dritten Oberfläche 340 beabstandet.

Figur 2 zeigt die Anordnung gemäß Verfahrensschritt b). Hierbei wird die Befestigungseinrichtung 16 mittels eines Befestigungsmittels 50, hier einer Klemmeinrichtung 52, genauer einer Federklemmeinrichtung, mit einer ersten Kraft 40 in Richtung auf die Kühleinrichtung 30, genauer derer dritte Oberfläche 340, beaufschlagt. Die Kühleinrichtung 34 weist zur Krafteinleitung ein Widerlager 36 für die Klemmeinrichtung 52 auf. Durch diese Beaufschlagung der Befestigungseinrichtung 16 mit der ersten Kraft 40 wird die Kontaktfläche 160 des Anschlagelements 16 auf die dritte Oberfläche 340 gedrückt. Hierbei wird, im Rahmen des technisch machbaren, das Anschlagelement 16 nicht verformt.

Gleichzeitig wird die Befestigungseinrichtung 14 gegenüber dem restlichen Gehäuse zumindest geringfügig verkippt, wodurch sich die erste Oberfläche 14 zumindest in einem Abschnitt der dritten Oberfläche 340 annähert, allerdings ohne mit dieser in Kontakt zu gelangen. Es kann hierbei auch eine gesamte geringfügige Verkippung des Gehäuses 10 samt Schalteinrichtung 20 gegenüber der dritten Oberfläche 340 erfolgen.

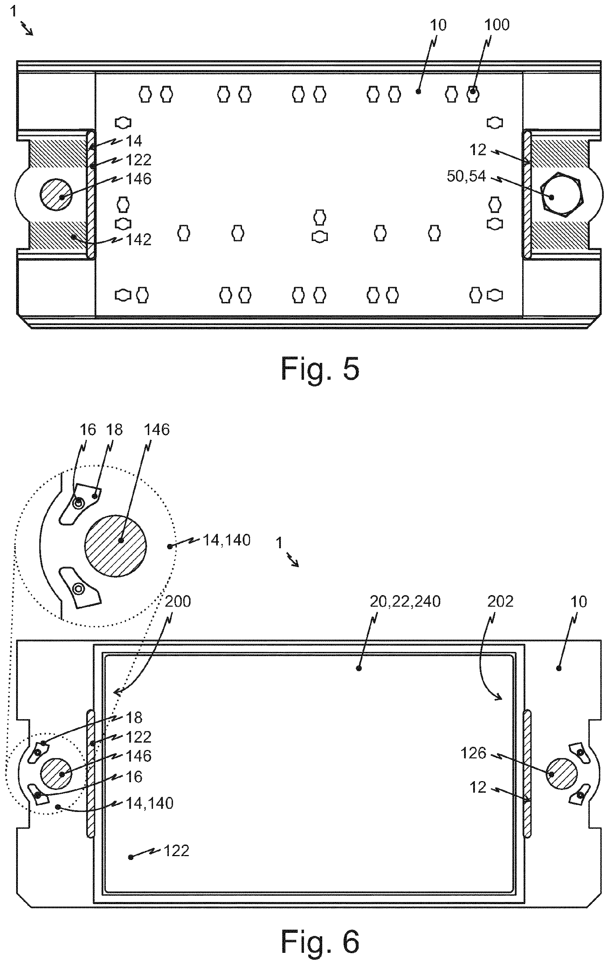

Im Anschluss an diesen hier dargestellten Verfahrensschritt b) erfolgt der Verfahrensschritt c), bei dem eine nicht dargestellte weitere Befestigungseinrichtung die vorzugsweise der ersten gegenüberliegt, vgl. auch Figuren 5 und 6, mit einer weiteren Kraft beaufschlagt wird.

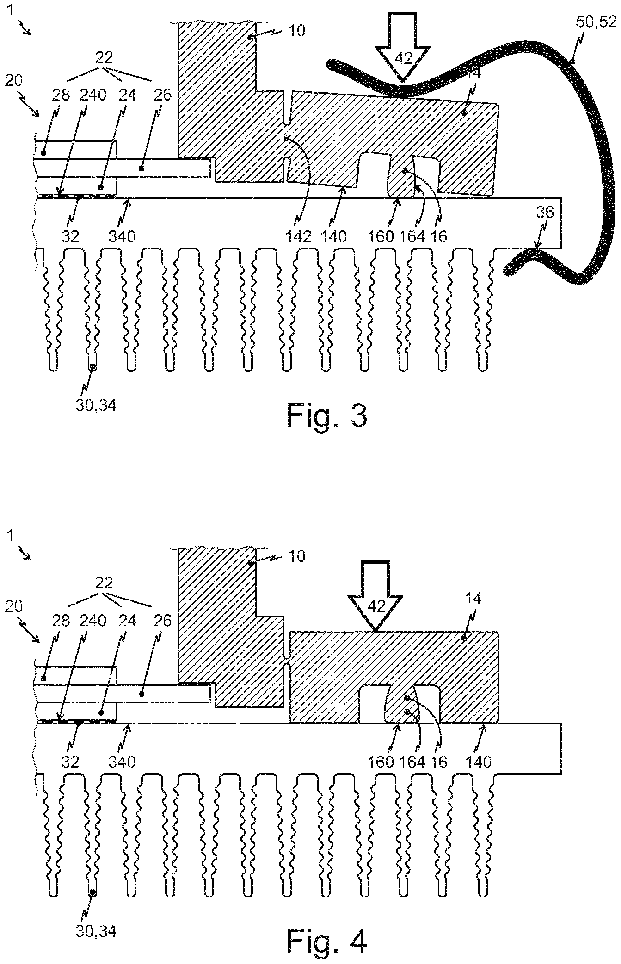

Figur 3 zeigt die Anordnung gemäß Verfahrensschritt d). Hierbei wird die Befestigungseinrichtung 14 mittels der Klemmeinrichtung 52 mit einer zweiten im Verglich zur ersten höheren Kraft 42 in Richtung auf die Kühleinrichtung 34, genauer derer dritte Oberfläche 340, beaufschlagt. Durch diese Beaufschlagung der Befestigungseinrichtung 14 mit der zweiten Kraft 42 wird die Kontaktfläche 160 des Anschlagelements 16 derart auf die dritte Oberfläche gedrückt, dass sich resultierend hieraus der Körper des Anschlagelements 16 verformt. Diese Verformung findet hierbei im Wesentlichen in der Vertiefung 18 des Befestigungselements 14 statt, wodurch sich ein Abschnitt 164 des Anschlagelements 16 fast vollständig in diese Vertiefung 18 hinein verformt. Durch die Verformung wird ein Teil, dreidimensional betrachtete eine Kante, der ersten Oberfläche 140 mit der dritten Oberfläche 340 in Kontakt verbracht. Nach diesem Verfahrensschritt d) sowie dem zuvor erfolgten Verfahrensschritt c) liegt das Leistungshalbleitermodul 1 insbesondere mit seiner zweiten Oberfläche 240 plan auf der dritten Oberfläche 340 der Kühleinrichtung 34 auf und die Montage auf der Kühleinrichtung 34 ist abgeschlossen.

Figur 4 zeigt eine zweite Ausgestaltung eines erfindungsgemäßen Leistungshalbleitermoduls 1, wiederum angeordnet auf einer Kühleinrichtung 34. Dargestellt sind grundsätzlich gleiche Komponenten wie unter Figur 3. Der hier erfolgte Verfahrensschritt ist ebenfalls d). Im Unterschied zur ersten Ausgestaltung liegt hier die erste Befestigungseinrichtung 14 nach Beaufschlagung mit einer zweiten Kraft 42 mit ihrer ersten Oberfläche 140 flächig auf der dritten Oberfläche 340 der Kühleinrichtung 34 auf. Diese flächige Auflage wird durch eine andere Ausgestaltung Verbindung, beispielhaft analog zur dritten Ausgestaltung, der ersten, wie auch einer nicht dargestellten weiteren, Befestigungseinrichtung 14 mit dem restlichen Gehäuse. Auch hier sind die Befestigungseinrichtungen 14 einstückig mit dem restlichen Gehäuse ausgebildet.

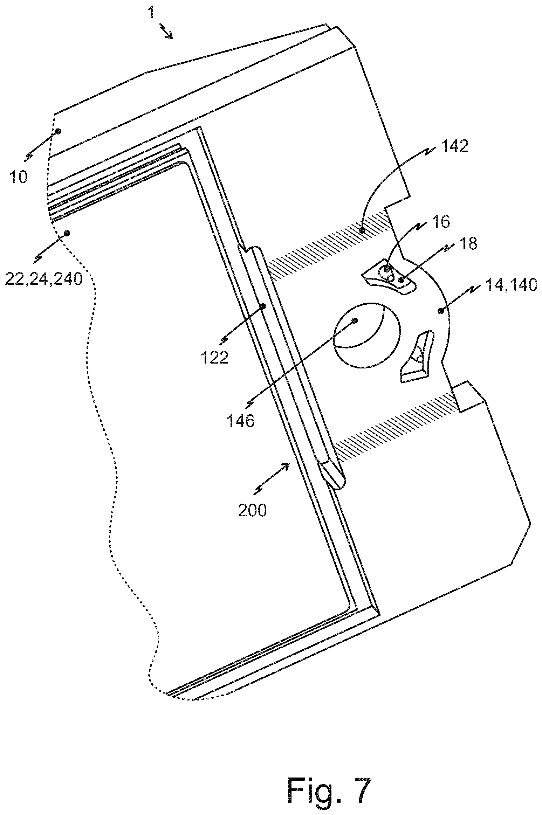

Figuren 5 bis 7 zeigen eine dritte Ausgestaltung eines erfindungsgemäßen Leistungshalbleitermoduls 1 in verschiedenen Ansichten. Hierbei zeigt Figur 5 eine Draufsicht von oben auf das Leistungshalbleitermodul 1, also in Richtung auf eine nicht dargestellte dritte Oberfläche des Grundkörpers. Figur 6 zeigt eine Draufsicht von unten, also auf die zweite Oberfläche 240 des Leistungshalbleitermoduls 1. Figur 7 zeigt eine dreidimensionale Teilansicht des Leistungshalbleitermoduls 1 von unten.

Das Leistungshalbleitermodul 1 weist ein Gehäuse 10 mit einer Mehrzahl von Durchbrüchen 100 auf, die der Durchführung von Anschlusselementen, beispielhaft in Form von Press-Pin-Kontaktelementen, dienen, die selbst aber nicht dargestellt sind. Das Gehäuse 10 umschließt in grundsätzlich fachüblicher Weise eine Schaltungseinrichtung 20 die eine Schaltungsträgerplatte 22 mit fachüblichem Aufbau, beispielhaft in Form eines DCB-Substrats, aufweist. Diese Schaltungsträgerplatte 22 weist eine zweite Oberfläche 240 zur Anordnung auf einem Grundkörper, fachüblich einer Kühleinrichtung, auf.

An den beiden sich gegenüberliegenden Schmalseiten 200, 202 der Schalteinrichtung 20 weist das Gehäuse 10 jeweils eine Befestigungseinrichtung 12, 14 auf, die aus Gründen der einfacheren Herstellung spiegelbildlich, aber identisch ausgebildet sind. Diese Befestigungseinrichtungen12, 14 sind im Bereich neben der Schalteinrichtung durch Längsschlitze 122 vom restlichen Gehäuse teilweise freigestellt. Somit kann sich der Bereich der Befestigungseinrichtungen 12 ,14, die eine Ausnehmung 126, 146 zur Durchführung eines Befestigungsmittels 50, hier genauer einer Schraube 54, aufweisen, in Richtung auf die dritte Oberfläche hin bewegen. Hierzu weist das Gehäuse 10 den Befestigungseinrichtungen 12, 14 zugeordnete Teilabschnitte 142 auf, die verformbar ausgebildet sind.

Die Befestigungseinrichtungen 12, 14 weisen weiterhin von deren erster Oberfläche 140 ausgehende jeweils zwei Vertiefungen 18 auf, die in unmittelbarer Nähe zu den Ausnehmungen 146, 126 und hier symmetrisch zur Längsachse des Leistungshalbleitermoduls 1 angeordnet sind. Auf der jeweiligen Grundfläche der Vertiefungen 18 ist der Fuß eines Anschlagelements 16 angeordnet. Selbstverständlich könnten die beide einer Befestigungsanordnung 12, 14 zugordneten Vertiefungen 18 auch zu einer einzigen entarten. In einer oder mehreren Vertiefungen können jeweils ein, zwei oder auch mehrere Anschlagelemente 16 angeordnet sein. Die hier dargestellten Anschlagelemente 16 weisen eine kegelstumpfartige Form auf.

## Patentansprüche

1. Leistungshalbleitermodul (1) mit einem Gehäuse (10) und mit einer Schaltungseinrichtung (20) zur Anordnung auf einem Grundkörper (30), wobei die Schaltungseinrichtung (20) eine Schaltungsträgerplatte (22) mit einer zweiten Oberfläche (240) aufweist, die dazu ausgebildet ist auf einer korrespondierenden dritten Oberfläche (340) des Grundkörper (30) angeordnet zu werden, wobei auf der der zweiten Oberfläche (240) abgewandten Seite der Schaltungsträgerplatte (22) weitere Komponenten angeordnet sind, wobei das Gehäuse (10) die Schaltungseinrichtung (20) zumindest an zwei einander gegenüber liegenden Seiten (200, 202) zumindest teilweise umschließt und dort jeweils eine Befestigungseinrichtung (14, 12) aufweist, wobei genau eine oder mindestens eine erste Befestigungseinrichtung (14) eine erste Oberfläche (140) aufweist, die eine parallel und versetzt zur zweiten Oberfläche (240) angeordnet und gegenüber der zweiten, aus Richtung der dritten Oberfläche (340), zurückversetzt ist und wobei die Befestigungseinrichtung (14) ein Anschlagelement (16) aufweist, das dazu ausgebildet ist eine erste Kraft (40), die die erste Oberfläche (140) in Richtung der dritten Oberfläche (340) drückt, ohne eigene Verformung, aufzunehmen und weiterhin bei einer zweiten, in die gleiche Richtung wirkenden, Kraft (42) verformt zu werden.

2. Leistungshalbleitermodul nach Anspruch 1, wobei
der Fuß (162) des Anschlagelements (16) in einer Vertiefung (18) der zugeordneten Befestigungseinrichtungen (14) angeordnet ist.

3. Leistungshalbleitermodul nach einem der vorhergehenden Ansprüche, wobei
das Anschlagelement (16) zylinder- oder kegelstumpfförmig ausgebildet ist.

4. Leistungshalbleitermodul nach einem der vorhergehenden Ansprüche, wobei
die jeweilige Befestigungseinrichtung (14, 12) eine Ausnehmung (146, 126) zur Durchführung eines Befestigungsmittels (50), insbesondere ausgebildet als eine Schraube (54), aufweist.

5. Verfahren zur kraftschlüssigen Anordnung eines Leistungshalbleitermoduls (1) gemäß einem der vorhergehenden Ansprüche auf einer dritten Oberfläche (340) eines Grundkörpers (30) mit folgenden Verfahrensschritten:
a) Loses Anordnen des Leistungshalbleitermoduls (1) mit seiner zweiten Oberfläche (240) auf der dritten Oberfläche (340), wobei zwischen der dritten Oberfläche (340) und der ersten Oberfläche (140) ein Abstand (440) besteht;
b) Beaufschlagen der ersten Befestigungseinrichtung (14) mit einer ersten Kraft (40), wodurch eine der dritten Oberfläche (340) zugewandte Kontaktfläche (160) des Anschlagelements (16) in Kontakt mit dieser dritten Oberfläche (340) verbracht wird, ohne dass das Anschlagelement (16) verformt wird;
c) Beaufschlagen einer weiteren Befestigungseinrichtung (12) mit einer weiteren Kraft;
d) Beaufschlagen der ersten Befestigungseinrichtung (14) mit einer zweiten Kraft (42), wodurch das Anschlagelement (16) verformt wird und somit der Abstand zwischen der ersten Oberfläche (140) und der dritten Oberfläche (340) verringert wird.

6. Verfahren nach Anspruch 5, wobei
bereits beim Schritt a) zwischen der zweiten (240) und dritten Oberfläche (340) eine, insbesondere thermisch leitende, Zwischenschicht (32) angeordnet ist.

7. Verfahren nach einem der Ansprüche 5 oder 6, wobei
das Beaufschlagen des ersten Befestigungseinrichtung (14) mittels eines ersten, insbesondere als eine Schraube (54) ausgebildeten, Befestigungsmittels (50) erfolgt, wobei das Befestigungsmittel (50) durch eine Ausnehmung (146) der zugeordneten Befestigungseinrichtung (14) ragt und sich in einem Widerlager des Grundkörpers (30) abstützt.

8. Verfahren nach einem der Ansprüche 5 oder 6, wobei
das Beaufschlagen der ersten Befestigungseinrichtung (14) mittels eines ersten, insbesondere als eine Klemmeinrichtung (52) ausgebildeten, Befestigungsmittels (50) erfolgt, wobei das Befestigungsmittel sich in einem Widerlager (36) des Grundkörpers (30) abstützt.

9. Verfahren nach einem der Ansprüche 5 bis 8, wobei
das Anlegen der zweiten, gegenüber der ersten größeren, Kraft (42) analog zum Anlegen der ersten Kraft (40) erfolgt.

10. Verfahren nach einem der Ansprüche 5 bis 9, wobei
beim Schritt d) die erste Oberfläche (140) in Kontakt mit der dritten Oberfläche (340) verbracht wird.

11. Verfahren nach einem der Ansprüche 5 bis 10, wobei
ein Fuß (162) des Anschlagelements (16) in einer Vertiefung (18) der zugeordneten Befestigungseinrichtungen (14) angeordnet ist und beim Schritt d) das Anschlagelement (16) derart verformt wird, dass ein ursprünglich über die erste Oberfläche (140) in Richtung der dritten Oberfläche (340) hinausstehender Abschnitt (164) des Anschlagelements (16) teilweise oder vollständig, vorzugsweise in diese Vertiefung (18) hinein, verformt wird.

12. Verfahren nach einem der Ansprüche 5 bis 11, wobei
der Grundkörper (30) als Kühleinrichtung (34) ausgebildet ist.

13. Verfahren nach einem der Ansprüche 5 bis 12, wobei
zumindest beim Verfahrensschritt d) ein Teilabschnitt (142) der ersten Befestigungseinrichtung (14) reversibel verformt wird.

14. Verfahren nach einem der Ansprüche 5 bis 12, wobei
zumindest beim Verfahrensschritt d) ein Teilabschnitt (142) der ersten Befestigungseinrichtung (14) irreversibel verformt wird.

## Claims

1. Power semiconductor module (1) having a housing (10) and having a switching device (20) for arrangement on a base element (30), wherein the switching device (20) comprises a circuit board (22) having a second surface (240), which is configured for arrangement on a corresponding third surface (340) of the base element (30), wherein further components are arranged on the side of the circuit board (22) which is averted from the second surface (240), wherein the housing (10) at least partially encloses the switching device (20) on at least two mutually opposing sides (200, 202), and at which location a fixing device (14, 12) is respectively arranged, wherein exactly one or at least one first fixing device (14) comprises a first surface (140), which is configured in a parallel offset arrangement to the second surface (240), and is recessed in relation to the second surface, from the direction of the third surface (340), and wherein the fixing device (14) comprises a stop element (16), which is configured to accommodate a first force (40), which compresses the first surface (140) in the direction of the third surface (340), without sustaining deformation, and moreover to sustain deformation in response to a second force (42), acting in the same direction.

2. Power semiconductor module according to Claim 1, wherein the foot (162) of the stop element (16) is arranged in a recess (18) in the associated fixing devices (14).

3. Power semiconductor module according to one of the preceding claims, wherein the stop element (16) is configured with a cylindrical or a truncated cone shape.

4. Power semiconductor module according to one of the preceding claims, wherein the respective fixing device (14, 12) incorporates a cut-out (146, 126) for the feedthrough of a fixing means (50), which is specifically configured as a screw (54).

5. Method for the materially bonded arrangement of a power semiconductor module (1) according to one of the preceding claims on a third surface (340) of a base element (30), comprising the following process steps:
a) Loose arrangement of the second surface (240) of the power semiconductor module (1) on the third surface (340), wherein a clearance (440) is provided between the third surface (340) and the first surface (140);
b) Application to the first fixing device (14) of a first force (40), as a result of which a contact surface (160) of the stop element (16) which faces the third surface (340) is brought into contact with said third surface (340), with no resulting deformation of the stop element (16);
c) Application of a further force to a further fixing device (12);
d) Application to the first fixing device (14) of a second force (42), as a result of which the stop element (16) undergoes deformation, and the clearance between the first surface (140) and the third surface (340) is reduced accordingly.

6. Method according to Claim 5, wherein
as early as step a), a specifically thermally conductive intermediate layer (32) is arranged between the second surface (240) and the third surface (340).

7. Method according to one of Claims 5 or 6, wherein
the application of the first fixing device (14) is achieved by means of a first fixing means (50), specifically configured as a screw (54), wherein the fixing means (50) projects through a cut-out (146) in the associated fixing device (14), and engages with an abutment of the base element (30).

8. Method according to one of Claims 5 or 6, wherein
the application of the first fixing device (14) is achieved by means of a first fixing means (50), specifically configured as a clamping device (52), wherein the fixing means engages with an abutment (36) of the base element (30).

9. Method according to one of Claims 5 to 8, wherein
the application of the second force (42), which is greater than the first, is executed analogously to the application of the first force (40).

10. Method according to one of Claims 5 to 9, wherein in step d), the first surface (140) is brought into contact with the third surface (340).

11. Method according to one of Claims 5 to 10, wherein
a foot (162) of the stop element (16) is arranged in a recess (18) in the associated fixing devices (14) and, in step d), the stop element (16) undergoes deformation such that a section (164) of the stop element (16) which originally stood proud of the first surface (140) in the direction of the third surface (340), either partially or entirely, is deformed, preferably into said recess (18).

12. Method according to one of Claims 5 to 11, wherein the base element (30) is configured as a cooling device (34).

13. Method according to one of Claims 5 to 12, wherein, at least in process step d), a subsection (142) of the first fixing device (14) is reversibly deformed.

14. Method according to one of Claims 5 to 12, wherein, at least in process step d), a subsection (142) of the first fixing device (14) is irreversibly deformed.

## Revendications

1. Module semi-conducteur de puissance (1), comprenant un boîtier (10) et un dispositif de circuit (20) pour l'agencement sur un corps de base (30), le dispositif de circuit (20) présentant une carte de support de circuit (22) avec une deuxième surface (240), qui est réalisée de manière à être disposée sur une troisième surface correspondante (340) du corps de base (30), des composants supplémentaires étant disposés du côté de la plaque de support de circuit (22) opposé à la deuxième surface (240), le boîtier (10) entourant au moins en partie le dispositif de circuit (20) au moins au niveau de deux côtés opposés (200, 202) et présentant à cet endroit à chaque fois un dispositif de fixation (14, 12), exactement un ou au moins un premier dispositif de fixation (14) présentant une première surface (140) qui est disposée parallèlement et de manière décalée par rapport à la deuxième surface (240) et qui est en retrait par rapport à la deuxième, à partir de la direction de la troisième surface (340), et le dispositif de fixation (14) présentant un élément de butée (16) qui est réalisé pour recevoir une première force (40) qui presse la première surface (140) dans la direction de la troisième surface (340), sans déformation propre et de manière en outre à être déformé dans le cas d'une deuxième force (42) agissant dans la même direction.

2. Module semi-conducteur de puissance selon la revendication 1, dans lequel
la base (162) de l'élément de butée (16) est disposée dans un renfoncement (18) des dispositifs de fixation associés (14).

3. Module semi-conducteur de puissance selon l'une quelconque des revendications précédentes, dans lequel l'élément de butée (16) est réalisé sous forme cylindrique ou tronconique.

4. Module semi-conducteur de puissance selon l'une quelconque des revendications précédentes, dans lequel le dispositif de fixation respectif (14, 12) présente un évidement (146, 126) pour le passage d'un moyen de fixation (50), en particulier réalisé sous forme de vis (54).

5. Procédé d'agencement par engagement par force d'un module semi-conducteur de puissance (1) selon l'une quelconque des revendications précédentes sur une troisième surface (340) d'un corps de base (30), comprenant les étapes de procédé suivantes :
a) disposition lâche du module semi-conducteur de puissance (1) avec sa deuxième surface (240) sur la troisième surface (340), une distance (440) existant entre la troisième surface (340) et la première surface (140) ;
b) sollicitation du premier dispositif de fixation (14) avec une première force (40), de sorte qu'une surface de contact (160) de l'élément de butée (16), tournée vers la troisième surface (340), soit amenée en contact avec cette troisième surface (340) sans que l'élément de butée (16) soit déformé ;
c) sollicitation d'un dispositif de fixation supplémentaire (12) avec une force supplémentaire ;
d) sollicitation du premier dispositif de fixation (14) avec une deuxième force (42), de sorte que l'élément de butée (16) soit déformé et que par conséquent la distance entre la première surface (140) et la troisième surface (340) soit réduite.

6. Procédé selon la revendication 5, dans lequel déjà à l'étape a) entre la deuxième (240) et la troisième (340) surface, est disposée une couche intermédiaire (32), notamment thermoconductrice.

7. Procédé selon l'une quelconque des revendications 5 et 6, dans lequel
la sollicitation du premier dispositif de fixation (14) s'effectue au moyen d'un premier moyen de fixation (50) notamment réalisé sous la forme d'une vis (54), le moyen de fixation (50) pénétrant à travers un évidement (146) du dispositif de fixation associé (14) et s'appuyant dans une contre-butée du corps de base (30).

8. Procédé selon l'une quelconque des revendications 5 et 6, dans lequel
la sollicitation du premier dispositif de fixation (14) s'effectue au moyen d'un premier moyen de fixation (50) notamment réalisé sous forme de dispositif de serrage (52), le moyen de fixation s'appuyant dans une contre-butée (36) du corps de base (30).

9. Procédé selon l'une quelconque des revendications 5 à 8, dans lequel
l'application de la deuxième force (42) supérieure par rapport à la première force s'effectue de manière analogue à l'application de la première force (40).

10. Procédé selon l'une quelconque des revendications 5 à 9, dans lequel
à l'étape d), la première surface (140) est amenée en contact avec la troisième surface (340).

11. Procédé selon l'une quelconque des revendications 5 à 10, dans lequel
une base (162) de l'élément de butée (16) est disposée dans un renfoncement (18) des dispositifs de fixation associés (14) et, à l'étape d), l'élément de butée (16) est déformé de telle sorte qu'une portion (164) de l'élément de butée (16) faisant initialement saillie au-delà de la première surface (140) dans la direction de la troisième surface (340), soit déformée partiellement ou complètement, de préférence dans ce renfoncement (18).

12. Procédé selon l'une quelconque des revendications 5 à 11, dans lequel
le corps de base (30) est réalisé sous forme de dispositif de refroidissement (34).

13. Procédé selon l'une quelconque des revendications 5 à 12, dans lequel
au moins à l'étape de procédé d), une portion partielle (142) du premier dispositif de fixation (14) est déformée de manière réversible.

14. Procédé selon l'une quelconque des revendications 5 à 12, dans lequel
au moins à l'étape de procédé d), une portion partielle (142) du premier dispositif de fixation (14) est déformée de manière irréversible.
